Europäisches Patentamt

European Patent Office

Office européen des brevets

(11) Publication number: **0 037 235 B1**

# EUROPEAN PATENT SPECIFICATION

(45) Date of publication of patent specification: **11.03.87**

(21) Application number: **81301253.1**

(22) Date of filing: **24.03.81**

(51) Int. Cl.⁴: **B 32 B 15/08,** B 60 R 13/02, C 23 C 14/00

(54) An article of manufacture, such as an automobile trim component, comprising a dielectric substrate with a surface coating of metal and a process of manufacturing same.

(30) Priority: **25.03.80 US 133857**

(43) Date of publication of application:
**07.10.81 Bulletin 81/40**

(45) Publication of the grant of the patent:
**11.03.87 Bulletin 87/11**

(84) Designated Contracting States:
**DE FR GB IT SE**

(56) References cited:
**BE-A- 370 887**
**DE-A-1 446 283**
**FR-A-1 191 334**
**FR-A-2 300 822**
**FR-A-2 352 666**
**GB-A-1 573 008**
**US-A-4 407 871**

**Handbook of thin film technology - MAISSEL and GLANG - IBM CORP:, pages 5-25 to 5-36**

(73) Proprietor: **EX-CELL-O CORPORATION**
**2855 Coolidge Highway**
**Troy Michigan 48084 (US)**

(72) Inventor: **Eisfeller, Richard C.**
**P.O. Box 96**
**Rollinsford New Hampshire 03869 (US)**

(74) Representative: **Wisher, Michael Frederick**
**Urquhart-Dykes & Lord 91 Wimpole Street**
**London W1M 8AH (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

### Technical field

This invention relates to an article of manufacture comprising a dielectric substrate, such as moulded plastics, with a metallic surface coating which may be deposited by vacuum metallizing and a process of manufacturing same, and is particularly, but not essentially, concerned with automobile trim components.

### Background art

Vacuum metallizing of plastics and similar dielectric substrates has been practised for some time, see U.S. Patents 2,993,806; 2,992,125; 3,914,472; and 4,131,530. The automobile industry has had a desideratum for metallized trim components that could be substituted for conventional chrome-plated metal parts. See "Restoring the Luster to Metallized Markets", *Modern Plastics*, December 1974, page 42, *et seq.*. However, weather-, abuse- and corrosion-resistance of such metallized plastics parts has been marginal. Work has been done in other fields with the vacuum depositing of indium, e.g. see Japanese Patent 15812/78 by Nobuyoshi Fujihashi and Hiroo Miyamoto. Work has also been reported on the effect of vacuum metallizing conditions on the deposited metal grain structure. See "Influence of Substrate Temperature and Deposition Rate on Structure of Thick Sputtered Cu Coatings" by John A. Thorton, *J. Vac. Sci. Technol.*, Vol. 12, No. 4 July/Aug. 1975, page 830, *et seq.*. No reference has been found that relates metal grain structure or grain spacing to the appearance of the product, to the conductivity of the metal layer, to the corrosion resistance of the metal layer and/or to the adhesion of a top coat.

Recently some commercial products have been made: see "Sputtering in Production at Chevrolet", *Industrial Finishing*, October, 1979, describing the Camaro Berlinetta grilles coated with a chrome alloy; "Alternatives to Conventional Chrome Plated Plastics" by D. M. Lindsey of the General Motors Chevrolet Engineering Center; and a "Critique on Current Preparation Techniques" by Hugh R. Smith, Jr. of Industrial Vacuuum Engineering, the latter two papers having been presented at the 1979 Society of Vacuum Coaters Annual Conference; "Ion Plating Using a Pure Ion Source: An Answer Looking for Problems", by Hale et al, Electronics Packaging and Production, May 1975, pg. 39 et seq; and "Continuous Vacuum Metallizing", Modern Plastics, December 1977, page 42 et seq.. What is interesting about all of these articles is that while they describe the supposed successful manufacture of exterior automobile trim components that can reasonably be expected to give the performance required in service, they all fail to give the slightest hint or whisper that the vacuum metallized products do not look or appear as they should—that they are in fact substantially darker appearing than electro-deposited chrome and thus donot have the bright sheeny chrome look and showroom sparkle that a purchaser of a new automobile expects and demands.

FR—A—2352866 describes a method of making a specular product by vacuum depositing a film of chromium, aluminium or stainless steel on to a flexible plastics substrate and applying a protection layer. The film is continuous as deposited and the product suffers from the common disadvantage of such known methods that, if the protective layer is broken, the metallic film soon oxidises away.

### Statement of invention and advantages

According to the present invention there is provided an article of manufacture comprising a dielectric substrate of plastics material with a metallic surface coating characterised in that the dielectric substrate has a smooth surface. In that the metallic surface coating is a layer of thickness of from 0.01 to 0.1 µm of minute metallic islands on said smooth surface which layer is thick enough to appear specular and continuous to the eye and is thin enough to be electrically non-conductive having a resistivity greater than 2.5 ohm-cm along the plane of the layer as deposited and at all times thereafter, in that a protective topcoating of an intimately adhered light-passing film is provided over the thin layer, and in that the metallic material of said layer is a corrosion-prone metal selected from the group consisting of indium, tin, silver, zinc, cadmium and combinations thereof.

Preferably the islands have an average diameter of less than 0.3 µm and the protective topcoating of an intimately adhered clear elastomeric film is at least 2.5 µm thick.

Still further according to the present invention there is provided a process of manufacturing an article comprising a dielectric substrate of plastics material with a metallic surface coating, the process being characterised in that a specular thin non-conductive metallic film of electrically discrete (as deposited) granular islands having a thickness of from 0.01 to 0.1 µm, an average grain size less than 0.3 µm, is deposited on a surface of the substrate by vacuum metallising a metal selected from the group consisting of indium, tin, silver, zinc, cadmium and combinations thereof and in that a protective topcoat is applied thereover.

Yet further according to the present invention there is provided an automobile trim component comprising a dielectric substrate with a metallic surface coating in accordance with the above invention. This product is particularly useful in the automobile industry as an automobile exterior trim component to replace heavier and more expensive conventional chrome-plated metal parts.

The present invention is based on the finding that with a thin vacuum metallised layer, if that layer is electrically non-conductive as deposited and thereafter, the metallic layer is corrosion-resistant if adequately topcoated. This can be so even if the bulk metal is not inherently corrosion-resistant. It appears that the metallic film to be non-conductive should be deposited as discrete "islands" electrically isolated from one another, and that if this is achieved corrosion resistance results. This is so as long as the coating is quite thin, such that there is insufficient metallic material deposited to bring about a bridging or coalescence of the metallic islands. For most metals, the metallic layer should be less than 0.1 μm thick, preferably less than 0.06 μm thick.

It has been further found that if the individual metallic islands have a diameter that is a fraction of the wave length of light, say a diameter of less than 0.35 μm, preferably less than 0.3 μm on the average, the metallic layer is quite bright and specular and not milky or whitish as occurs when the island size exceeds about 0.4 μm. If indium is the metal deposited, the appearance of the metallic layer looks much like that of chrome plate.

While commercial products have heretofore been made from metals or metal alloys that are inherently corrosion-resistant such as chromium or stainless steel, such vacuum metallized films are dark and unsatisfactory-appearing. The present invention, however, permits the use of metals which are not inherently corrosion-resistance such as aluminium and silver and thus permit one to obtain a better colour match with electrodeposit chrome. An indium coating is particularly good in this regard.

The metallic film can be deposited by thermal evaporization, sputtering, ion plating, induction heating, electron beam evaporization and like methods; see "Thin Film Technology", by Berry et al, D. Van Nostrand Company, Inc., Princeton, New Jersey, 1968, Lib. of Cong. 68—25817. If the metallizing is carried out in a manner to secure a low rate of deposition of the metal atoms the formation of the desired electrically discontinuous coating is enhanced. Also, better or more uniform coverage appears to be secured especially with objects having corners, edges, or recesses if some atoms of an inert gas such as argon are present in the vacuum chamber in excess of those required for the evaporation. The vacuum deposition is preferably carried out at a vacuum of $5 \times 10^{-3}$ Torr or less.

Specularity drops as the diameter of the grain nears the wave lengths of visible light.

The deposited metallic layer should not be too thin as it becomes transparent and reflectance drops off. Generally speaking for most metals the deposited film should have a thickness of at least 0.01 μm.

Another finding embodied in this invention is that when proper grain distinction is obtained improved adhesion of the protective plastics topcoat results. This adhesion can be measured, for example, by the Ford adhesion test, Specification No. ESB—M2P—105B, or the Chevrolet tape adhesion test, Specification No. CTZ VM003 AA. This improved adhesion appears to be related to the amount of separation between the individual metallic islands, i.e. to the distinctiveness of the islands, rather than to the diameter or size of the islands.

For most applications, the deposited metallic film must be protected with a topcoat to improve resistance to mechanical abuse and protect the metallic material from weathering and oxidation. Clear moisture resistant acrylic, urethane, epoxy, and like coatings applied as a latex and more preferably as a solvent solution are suitable. For critical applications the topcoat will often be baked to assure that a good tough continuous film is produced. The plastics film appears to fill the interstices and voids between the individual metallic islands and helps further isolate one island from another. Once so protected, if the surface is exposed to a corrosive medium tending to promote oxidation of the metallic layer and if the plastics film in one minute area is breached by the medium with oxidation of some of the metallic islands contiguous to the breach, the blight does not spread along the metallic film because of the electrical isolation of the islands.

This invention is applied to metals which are not inherently strongly corrosion-resistant: silver, zinc, indium, tin, or cadmium, and combinations thereof as opposed to stainless steel, gold, platinum, chromium, nichrome, palladium and rhodium, some of the latter such as rhodium are prohibitively expensive.

Indium gives an excellent colour match to chrome plate and is the preferred metal in the preparation of automobile trim components.

Any suitable dielectric, i.e. electrically insulating, material can be used to receive the vacuum deposited metallic film such as dry wood, glass or plastics. For the intended automobile trim component application a castable or mouldable plastics is used, preferably an elastomer that is tough and abuse-resistant with some flexibility such as an injection moulding grade thermoplastics polyurethane (TPU). By "flexible elastomer" is meant a natural or synthetic thermoplastics or thermoset plastics or polymer having an extensibility of greater than approximately 30% as compared to "rigid" plastics which has an extensiblity of less than 10%. Of course, for many applications where the article will not be subjected to mechanical abuse, rigid plastics are perfectly suitable, such as for instrument cluster trim or grilles. Examples of suitable rigid plastics are polyolefin, such as a polypropylene, a polyacrylonitrile-Butadiene-styrene and a polycarbonate.

The nature of the flexible substrate does not appreciably affect the performance of the applied coatings. The substrate cannot be so stiff or rigid that it will not serve its intended function as a flexible trim component nor can it be too flexible or elastomeric. The present coating system can be applied over such flexible substrates as reaction injection moulded urethane, thermoplastics olefins, nylon, rubber and polycarbonates. A suitable primer may be necessary to smooth or gain adherence to the substrate. The present coating system can, of course, be applied and used with substantially more rigid substrates, but other methods of bright trimming such as electroplating might be more economical to use on firm or hard surfaces.

The vacuum deposited metallic layer "mirrors" the surface on which it is deposited, i.e. the surface smoothness or roughness shows up in the deposited metallic layer. For bright sheeny parts it is preferred to have the surface on to which the metallic layer is deposited to be as smooth as possible. Flame or thermally reflowed urethanes are particularly useful in this regard. Often it is desirable to overcoat the base plastics with a clear or pigmented basecoat of some sort prior to the carrying out of the vacuum deposition step. Pigmented prime coats can be used to obtain an initial levelling of the base plastics surface following which a clear or pigmented base coat can be applied to give a mirror smooth surface. These layers can be heat treated or baked as required to develop their maximum properties. If a urethane substrate is used, weatherability of the article may be improved by using a pigmented base coat that prevents light penetration to the plastics base. Light can pass through the metallized layer in amounts sufficient to have a degrading effect on the lower plastics layers.

Sputtering and thermal evaporation are preferred methods of laying down the metallic layer although the use of ion plating, induction heating or electron beam evaporation methods are not precluded so long as they give the discrete island structure that results in electrical non-conductivity.

Following the deposition of the metallic layer and clear plastics topcoat, preferably one resistant to moisture penetration, is applied. Generally the thickness of the topcoat will be at least 2.5 µm thick (dry basis) and usually will not exceed 125 µm thick, for flexible exterior automobile trim, the topcoat is necessarily elastomeric and if thermosetting, it can be thoroughly baked, for example at 120°C or so, to develop its maximum properties. The topcoat is formulated to adhere both to the metallic film as well as to the base plastics.

As the metallic film exists as discrete islands flexing or bending of the metallic film will not result in the further macro cracking of the metallic layer and there is therefore no objectionable change in its appearance when the plastics part is bent or stretched and the stress is released.

Figures of the drawings

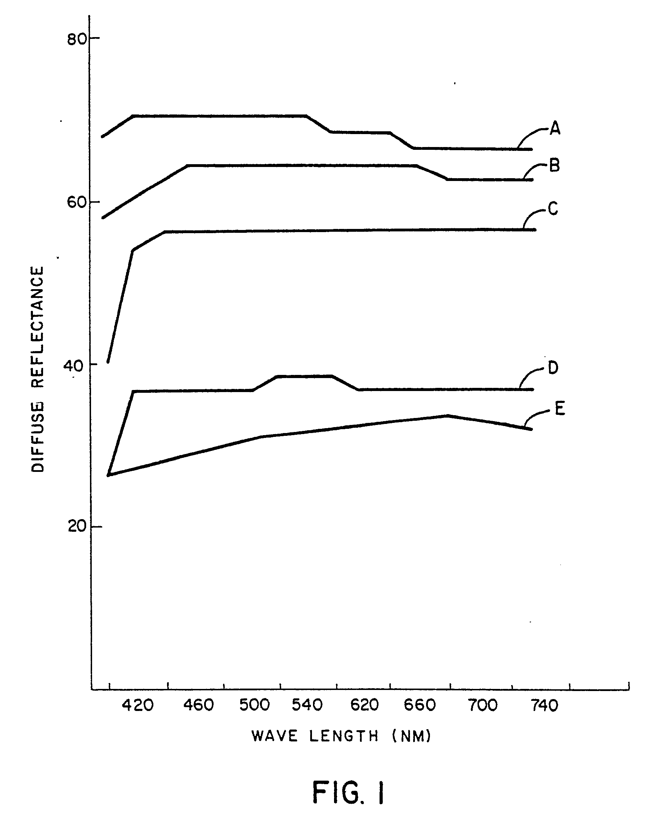

The present invention will now be further described, by way of example only, with reference to the accompanying drawings, in which Figure 1 is a graph comparing the percent diffuse reflectance (the ordinate) of a metallized coating by this invention against comparative coatings at various wave lengths of visible light spectrum expressed in nanometers (the axis) (except for Example A, all the samples were topcoated);

Figure 2 is a micro photograph taken with a scanning electron microscope at 44,000 magnification of an indium layer prepared by thermal evaporation in accordance with the process of this invention (the view angle is 45° and the grains have an average grain diameter of about 0.18 µm); and

Figure 3 is a similar micro photograph of a similarly prepared indium coating except that the average island size is about 0.45 µm (this coating, while having a diffuse reflectivity of 82% before topcoating, was quite milky, was definitely conductive and had poor corrosion resistance).

Detailed description of the drawings

The coatings giving the data of Figure 1 were obtained using a Thermal Evaporator made by Consolidated Vacuum Corporation, Rochester, New York. Unless otherwise described, flat plaques were prepared for testing. The reflectances were obtained with an Integrated Sphere Spectrophotometer with specular component included, Model ACS—500S, made by Applied Color Systems, Inc., U.S. Highway 1, Princeton, New Jersey. A barium sulphate surface has a diffuse reflectance of 100% on this scale.

In Figure 1, line A is a plot of the reflectance of conventional electroplated chromium surface, used as a standard or goal.

Line B is a plot of the reflectance of an article in accordance with this invention, being about a 2.2 micron thick coating of indium with a clear topcoat, prepared as set out hereinafter in the Examples. It can be seen that the diffuse reflectance of the indium coating compares favourably with that of electro-deposited chrome. The indium without the topcoat has a higher reflectance than that of the chrome but the addition of the topcoat tones the reflectance down to what is illustrated.

Line C gives the reflectance of a sputtered chromium surface topcoated with the same topcoat as in B. It can be seen that sputtered chromium, which has a higher reflectance than chromium vacuum deposited by other techniques, is substantially darker than electro-deposited chromium.

Line D is the chrome alloy used for the Camaro Berlinetta (Trade Mark) TPU grille as described in the *Industrial Finishing* article, *supra*, the measurement having been obtained from the part itself. It can be seen that the appearance of the part is dark and unsatisfactory, which is why perhaps it is used in an unobtrusive location and manner.

Line E shows the least satisfactory metallized coating tested and yet this coating was described by the Pennwalt Corporation as being highly reflective—as having "solved" the problem of bright metal plastics finishing. See the "Continuous Vacuum Metallizing" article *supra*, page 45. These data were obtained from a topcoated chromium alloy metallized sample, the metal of which was thermally evaporated by Pennwalt.

Well prepared topcoated sputtered stainless steel is slightly darker than Line C.

The minimum resistance at which the vacuum metallized layer becomes conductive and corrosion prone is difficult to establish. By the following procedure it was determined that a thin film or indium when deposited with sufficient thickness had a resistivity of about 5 ohms, which jumped to over 100 megaohms as the deposited metal film was made thinner down to about 25 milli-micrometers. Intermediate resistivity values between these two could not be established. The test was carried out with a Megger brand (Trade Mark) insulation tester supplied by the Biddle Company of Plymouth Meeting, Pennsylvania. Test strips of the vacuum deposited indium were prepared on a dielectric plastics base. The strips were 1/2" (12.7 mm) wide×1.1/2" (38 mm). A 1/2" (12.7 mm) section at each end was used for copper contact pads from the tester, leaving a 1/2" (12.7 mm) square centre section as the test area. 500 volts were applied to the contact pads to obtain the indicated readings. By suitable calculation, it can be shown that the 100+megaohm resistance value translated, when considering the thickness of the metal film, to a resistivity of 2.5 ohm cm.

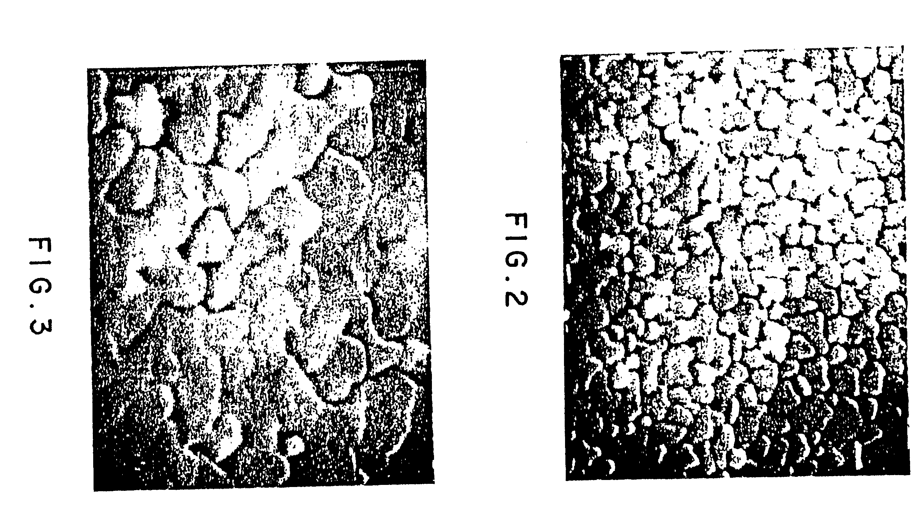

Figure 2 shows the granular, island surface of an indium coating thermally evaporated onto a substrate plastics plaque having a composition as in Example 1. The coating thickness was about 0.025 μm and the average grain size was 0.18 μm. The diffuse reflectivity of the coating (without topcoat) was 74%. The coating was non-conductive by the above test and corrosion resistant when topcoated.

A similar sample was prepared having an average particle size of about 0.36 μm. It had a reflectivity of 80% (not topcoated) but was hazy in appearance with a bluish cast. It was marginally non-conductive. The islands apparently had started to grow together.

The coating of Figure 3 was milky in appearance, had a reflectivity of 82% (not topcoated), and was definitely conductive with a grain size of 0.45 μm, which definitely exceeds acceptable limits.

EXAMPLES
Example 1

The sample part is a 1980 Cougar (Trade Mark) Chin Grille, Chevrolet Part No. XR7—234, injection moulded with Goodrich 58130 thermoplastics urethane (TPU). A urthane enamel basecoat is applied over the grille. It is a standard production item supplied by PPG Industries, as ESP3967. This coating is a melamine modified blocked aliphatic urethane. This coating is light stable and is pigmented white to block light from reaching non-light stable substrates. The basecoat is thinned and sprayed according to manufacturer's instructions onto the properly cleaned surface at room temperature to a thickness of 25.4±5.1 μm (dry basis). The applied coating requires an air flash of 20 minutes and is then baked for approximately 60 minutes at approximately 120°C to reach full properties.

After the grille is cooled to room temperature it is vacuum metallized with indium thermally evaporated at low power from boats according to the following procedure:

A bell jar is pumped down to $1\times10^{-5}$ Torr and then back-filled with argon to $3\times10^{-4}$ Torr. The pumping system for the bell jar consists of a mechanical roughing pump, a silicone oil diffusion pump, and a liquid nitrogen coldtrap to minimize organic and water vapour in the bell jar. The function of the argon backfill is to obtain better coverage on three dimensional parts. The indium is thermally evaporated from a 0.25 μm tungsten boat (4.3/4" (121 mm) length, 1/8" (3.2 mm) dimple×1.1/2" (38 mm) long) connected to series to a 5 volt AC variable transformer. The grille is rotated at 21 RPM with source to substrate varying during rotation from 8.1/2" (216 mm) to 14.1/2" (368 mm). The boat is pre-heated at 200 amps for 10 seconds. The power is raised to 235 amps for 70 seconds and indium is evaporated at a rate of 0.00025 to 0.0004 μm per second.

The topcoat is a solvent-based aliphatic urethane prepared from 753 parts Union Carbide Hylene W (Trade Mark), 506 parts Union Carbide PCP-0300 polycaprolactone polyol, 240 parts hexanediol adipate, and 23 parts Dow Corning DC-193 (Trade Mark) silicone. The topcoat is spray applied at 17% solids to a thickness of 25.4±5.1 μm (dry basis). The coating is air flashed for 20 minutes and then baked for 60 minutes at approximately 120°C to reach full properties.

The completed composite gives the following performance against the Ford ESB—M2P105—B Elastomeric Exterior Paint Performance Specification:

1. Colour—Very specular and an excellent colour match to chrome plate.
2. Adhesion—Pass.
3. Flexibility—Pass.
4. Water Resistance—Pass.
5. Weathering Resistance—Pass.
6. Thermal Shock Resistance—Pass.
7. Resistance to Water and Soap Spotting—Slight spotting.
8. Resistance to Acid Spotting—Pass.
9. Petrol Resistance—Pass.
10. Oil Resistance—Pass.
11. Resistance to Scuffing—Pass.
12. Heat Resistance—Pass.
13. Chip Resistance—Acceptable, same as pigmented flexible exterior coatings.
14. Cold Flexibility—Pass.
15. Resistance to Galvanic Action—Pass.

In addition, this composite passes the Ford Thermal Cycle—Corrosion Test from its Exterior Electroplating Specification ESB—M1P47—A.

Example 2

The sample part is a 1979 Ford Pinto (Trade Mark) Bezal. Part No. D7EB—16018—AWA, reaction injection moulded from thermo-setting urethane. The part is primed with PPG DEL—32906 (Trade Mark) grey urethane primer to give a smooth surface for basecoat application. Application is according to manufacturer's instructions and the primer is sprayed to a 25.4±5.1 μm thickness. The bake for this coating is 10 minutes at approximately 120°C. The basecoat, metal layer, and topcoat are the same as in Example No. 1.

Example 3

The part, basecoat, and metal layer are the same as in Example No. 1. The topcoat is Celenese 84—7609 (Trade Mark) urethane topcoat sprayed to a dry film thickness of 25.4±5.1 µm. The coating is air flashed for 20 minutes and then baked one hour at approximately 120°C to reach full properties.

The full names and addresses of companies mentioned *supra* are:—

| | |
|---|---|
| Chevrolet | Chevolet Motor Division Flint, Michigan. |
| Goodrich | F. F. Goodrich Company 3135 Euclid Avenue Cleveland, Ohio 44115 |
| PPG Industries | PPG Industries 3800 W. 143rd Street Cleveland, Ohio |
| Union Carbide | Union Carbide Chemicals and Plastics South Charleston, W. Virginia 25303 |
| Celanese | Celanese Chemical Company. Inc. 1481 South 11th Street Louisville, Kentucky 40208 |
| Ford | Ford Motor Company Dearborn, Michigan |

**Claims**

1. An article of manufacture comprising a dielectric substrate a plastics material with a metallic surface coating characterised in that the dielectric substrate has a smooth surface, in that the metallic surface coating is a layer of thickness of from 0.01 to 0.1 µm of minute metallic islands on said smooth surface which layer is thick enough to appear specular and continuous to the eye and is thin enough to be electrically non-conductive having a resistivity greater than 2.5 ohm-cm along the plane of the layer as deposited and at all times thereafter, in that a protective topcoating of an intimately adhered light-passing film is provided over the thin layer, and in that the metallic material of said layer is a corrosion-prone metal selected from the group consisting of indium, tin, silver, zinc, cadmium and combinations thereof.

2. An article according to claim 1 characterised in that the islands have an average diameter of less than 0.3 µm and in that the protective topcoating is at least 2.5 µm thick.

3. An article of manufacture according to claim 1 or claim 2 characterised in that said dielectric substrate is a flexible elastomeric plastics having an extensibility greater than 30% at 20°C.

4. An article of manufacture according to claim 3 characterised in that said dielectric substrate comprises a moulded thermoplastics urethane basecoated to give a smooth surface with a pigmented film-forming elastomer.

5. An article of manufacture according to claim 1 or claim 2 characterised in that said dielectric substrate comprises a rigid plastics having an extensibility of less than 10% and selected from the group consisting of polyolefin, polyacrylonitrile butadiene-styrene, and polycarbonates.

6. A process of manufacturing an article comprising a dielectric substrate of plastics material with a metallic surface coating, the process being characterised in that a specular thin non-conductive metallic film of electrically discrete (as deposited) granular islands having a thickness of from 0.01 to 0.1 µm, an average grain size less than 0.3 µm, is deposited on a surface of the substrate by vacuum metallising a metal selected from the group consisting of indium, tin, silver, zinc, cadmium and combinations thereof and in that a protective clear topcoat is applied thereover.

7. A process according to claim 6 characterised in that said vacuum metallising is by thermal evaporation.

8. A process according to either of claims 6 and 7 characterised in that the dielectric substrate comprises a moulded plastics base and in that the topcoat comprises moisture-resistant plastics material and is applied from a fluid vehicle.

9. An automobile trim component comprising a dielectric substrate with a metallic surface coating as claimed in any of claims 1 to 5.

**Patentansprüche**

1. Fertigungsgegenstand, der ein dielektrisches Substrat aus Kunststoff mit einer metallischen Oberflächenbeschichtung aufweist, dadurch gekennzeichnet, daß das dielektrische Substrat eine glatte Oberfläche hat, daß die metallische Oberflächenbeschichtung eine Dickenschicht von 0,01 bis 0,1 µm winziger metallischer Inseln auf der glatten Oberfläche ist, welche dick genug ist, um für das Auge spiegelnd und durchgehend zu erscheinen und dünn genug, um elektrisch nichtleitend zu sein, wobei sie einen spezifischen Widerstand von mehr als 2,5 Ohm-cm längs der Ebene der Schicht, so wie sie niedergeschlagen ist und zu allen Zeiten danach, hat, daß über der dünnen Schicht ein schützander Decküberzug aus einem innig anhaftenden, Licht durchlassenden Film vorgesehen ist, und daß der metallische Werkstoff der Schicht ein zu Korrosion neigendes, aus der aus Indium, Zinn, Silber, Zink, Cadmium und Kombinationen derselben bestehenden Gruppe ausgewähltes Metall ist.

2. Gegenstand nach Anspruch 1, dadurch gekennzeichnet, daß die Inseln einen durchschnittlichen Durchmesser von weniger als 0,3 µm haben, und daßder schützende Decküberzug mindestens 2,5 µm dick ist.

3. Fertigungsgegenstand nach Anspruch 1 oder 2, dadurch gekennzeichnet, daß das dielektrische Substrat ein flexibler, elastomerer Kunststoff ist, der eine Dehnfähigkeit von mehr als 30% bei 20°C hat.

4. Fertigungsgegenstand nach Anspruch 3, dadurch gekennzeichnet, daß das dielektrische Substrat ein geformtes thermoplastisches Urethan mit einem gefärbten, einen Film bildenden Elastomer als Grundstrich zur Schaffung einer glatten Oberfläche aufweist.

5. Fertigungsgegenstand nach Anspruch 1 oder 2, dadurch gekennzeichnet, daß das dielektrische Substrat einen steifen Kunststoff aufweist, der eine Dehnfähigkeit von weniger als 10% hat und aus der aus Polyolefin, Polyacrylnitril, Butadienstyrol und Polykarbonaten bestehenden Gruppe ausgewählt ist.

6. Verfahren zur Fertigung eines Gegenstandes, der ein dielektrisches Substrat aus Kunststoff mit einer metallischen Oberflächenbeschichtung aufweist, dadurch gekennzeichnet, daß ein spiegelnder, dünner, nichtleitfähiger, metallischer Film aus elektrisch einzelnen (so wie niedergeschlagen), körnigen Inseln einer Dicke von 0,01 bis 0,1 µm, einer durchschnittlichen Körnchengröße von weniger als 0,3 µm auf einer Oberfläche des Substrats durch Vakuummetallisieren eines aus der aus Indium, Zinn, Silber, Zink, Cadmium und Kombinationen derselben bestehenden Gruppe ausgewählten Metalls niedergeschlagen wird, und daß darüber ein schützender, durchsichtiger Decküberzug aufgetragen wird.

7. Verfahren nach Anspruch 6, dadurch gekennzeichnet, daß das Metallisieren unter Vakuum durch thermisches Verdampfen geschieht.

8. Verfahren nach einem der Ansprüche 6 oder 7, dadurch gekennzeichnet, daß das dielektrische Substrat eine geformte Kunststoffbasis aufweist, und daß der Decküberzug feuchtigkeitsbeständigen Kunststoff aufweist und aus einem Fluidträger aufgetragen wird.

9. Ein Automobildekorationsteil, welches ein dielektrisches Substrat mit einer metallischen Oberflächenbeschichtung nach einem der Ansprüche 1 bis 5 aufweist.

**Revendications**

1. Objet manufacturé, comprenant un substrat diélectrique en matière plastique ayant un revêtement de surface métallique, caractérisé en ce que le substrat diélectrique a une surface lisse, en ce que le revêtement de surface métallique est une couche d'épaisseur comprise entre 0,01 et 0,1 µm de petits îlots métalliques sur ladite surface lisse, laquelle couche est suffisamment épaisse pour apparaître spéculaire et continue à l'oeil et est suffisamment fine pour être électriquement non-conductrice en ayant une résistivité supérieure à 2,5 ohm-cm le long du plan de la couche comme déposée et à tout moment par la suite, en ce qu'un revêtement supérieur protecteur d'un film transparent collé intimement est prévu sur la couche fine, et en ce que le matériau métallique de ladite couche est un métal sujet à la corrosion choisi dans le groupe constitué de l'indium, l'étain, l'argent, le zinc, le cadmium et leurs combinaisons.

2. Objet selon la revendication 1, caractérisé en ce que les îlots ont un diamètre moyen de moins de 0,3 µm et en ce que le revêtement supérieur protecteur a une épaisseur d'au moins 2,5 µm.

3. Objet manufacturé selon la revendication 1 ou la revendication 2, caractérisé en ce que ledit substrat diélectrique est un plastique élastomère flexible ayant une extensibilité supérieure à 30% à 20°C.

4. Objet manufacturé selon la revendication 3, caractérisé en ce que ledit substrat diélectrique comprend une couche de base d'uréthane thermoplastique moulée pour donner une surface lisse avec un élastomère formant film pigmenté.

5. Objet manufacturé selon la revendication 1 ou la revendication 2, caractérisé en ce que ledit substrat diélectrique comprend un plastique rigide ayant une extensibilité inférieure à 10% et choisi dans le groupe constitué des polyoléfines, du polyacrylonitrile butadiène-styrène, et des polycarbonates.

6. Procédé de fabrication d'un objet comprenant un substrat diélectrique en matière plastique avec un revêtement de surface métallique, le procédé étant caractérisé en ce que un film métallique non-conducteur fin spéculaire d'îlots granulaires électriquement discontinus (comme déposés) ayant une épaisseur comprise entre 0,01 et 0,1 µm, une taille de grain moyenne inférieure à 0,3 µm, est déposé sur une surface du substrat en métallisant sous vide un métal choisi dans le groupe constitué de l'indium, de l'étain, de l'argent, du zinc, du cadmium et leurs combinaisons et en ce qu'un revêtement supérieur, clair et protecteur est appliqué sur celui-ci.

7. Procédé selon la revendication 6, caractérisé en ce que ladite métallisation sous vide est réalisée par évaporation thermique.

8. Procédé selon l'une des revendications 6 et 7, caractérisé en ce que le substrat diélectrique comprend une base en plastique moulée et en ce que le revêtement supérieur comprend un matériau plastique résistant à l'humidité et est appliqué à partir d'un agent fluide.

9. Enjoliveur pour automobiles comprenant un substrat diélectrique avec un revêtement de surface métallique comme revendiqué dans l'une des revendications 1 à 5.

FIG. 1

1

FIG.2

FIG.3